Europäisches Patentamt

European Patent Office

Office européen des brevets

(11) Veröffentlichungsnummer: **0 348 752 B1**

# EUROPÄISCHE PATENTSCHRIFT

(45) Veröffentlichungstag der Patentschrift: **16.12.92**

(51) Int. Cl.⁵: **H05K 3/26**, B08B 3/12

(21) Anmeldenummer: **89110930.8**

(22) Anmeldetag: **16.06.89**

(54) **Vorrichtung und Verfahren zur Reinigung und Behandlung von horizontal bewegten Leiterplatten.**

(30) Priorität: **29.06.88 DE 3821980**

(43) Veröffentlichungstag der Anmeldung:
**03.01.90 Patentblatt  90/01**

(45) Bekanntmachung des Hinweises auf die
Patenterteilung:
**16.12.92 Patentblatt  92/51**

(84) Benannte Vertragsstaaten:
**BE CH DE ES FR GB IT LI LU NL SE**

(56) Entgegenhaltungen:
**EP-A- 0 044 800**
**EP-A- 0 212 253**
**DE-B- 1 121 901**
**US-A- 2 845 077**

(73) Patentinhaber: **SCHERING AKTIENGESELL-
SCHAFT Berlin und Bergkamen
Müllerstrasse 170/178 Postfach 65 03 11
W-1000 Berlin 65(DE)**

(72) Erfinder: **Schröder, Rolf
Dambockstrasse 25
W-1000 Berlin 27(DE)**
Erfinder: **Kallweit, Manfred
Ragniter Allee 3a
W-1000 Berlin 19(DE)**

## Beschreibung

Die Erfindung betrifft eine Vorrichtung zur Ultrareinigung von horizontal bewegten Leiterplatten mit flüssigen Reinigungsmitteln, enthaltend einen Behälter für die flüssigen Reinigungsmittel sowie mindestens eine Düse zur Beschwallung der Leiterplatten und insbesondere ihrer Bohrlöcher zum Zwecke einer intensiven Durchflutung unter Ausbildung einer vorzugsweise stehenden Welle sowie Antriebssysteme für die Leiterplatten, vorzugsweise durch Rollen und Abdichtungen zur Verhinderung des Austretens von Flüssigkeit bei der Einbringung in bzw. Ausbringung aus dem Behälter sowie Ultraschallschwinger.

Leiterplatten für gedruckte Schaltungen, die durch Bohrlöcher die beiden Oberflächen oder innerhalb der Isolierfläche nach der Aktivierung und Metallisierung, dem sogenannten Durchkontaktisierungsprozess, miteinander verbinden, sind in ihrer Funktionsfähigkeit in hohem Maße davon abhängig, ob die jeweiligen Verunreinigungen exakt entfernt werden können.

Verfahren und Einrichtungen zum Reinigen von derartigen Kontaktierungslöchern in Leiterplatten sind bereits bekannt (DE PS 26 06 984). Diese Verfahren und Einrichtungen weisen indessen relativ niedrige Durchströmgeschwindigkeiten verbunden mit längeren Behandlungszeiten auf, was verbesserungsbedürftig ist.

Es ist weiterhin ein Verfahren bekannt geworden, bei dem die Leiterplatte mit konstanter Geschwindigkeit über eine Schwallstrecke hinwegläuft, die von einer unterhalb der Transportbahn und senkrecht zur Transportrichtung angeordneten Düse gebildet wird, aus dem das flüssige Behandlungsmittel in Form einer stehenden Welle an die Unterseite der Leiterplatte gefördert wird und eine Einrichtung zur Durchführung dieses Verfahrens, in deren oberen Teil ein Ultraschallschwinger angeordnet ist (DE US 35 28 575).

Unbefriedigend ist hierbei, daß die Erzeugung eines gerichteten homogen Schallfeldes eine Vielzahl von Einzelelementen erforderlich macht, wodurch die Einrichtung zwangsläufig überdimensioniert wird.

Aufgabe der vorliegenden Erfindung ist die Schaffung einer Vorrichtung und eines Verfahrens, welche eine Ultrareinigung von Leiterplatten unter Anwendung eines gerichteten Schallfeldes mit nur sehr wenigen Einzelelementen ermöglicht.

Diese Aufgabe wird erfindungsgemäß durch eine Vorrichtung gemäß dem kennzeichnenden Teil des Patentanspruchs 1 gelöst.

Weitere Ausführungsformen der Erfindung sind den Kennzeichnungsteilen der Unteransprüche zu entnehmen.

Die erfindungsgemäße Vorrichtung ermöglicht eine gegenüber den hierfür bekannten Einrichtungen gesteigerte Reinigungswirkung und hat den besonderen Vorteil weniger Raum als diese zu beanspruchen.

Der erfindungsgemäß verwendete Ultraschallschwinger ist ansich bekannt und wird z. B. in der EP 0044800 beschrieben.

Als flüssige Reinigungsmittel können zum Beispiel Wasser, Säuren, wie Schwefelsäure, oder Basen sowie Oxidationsmittel wie wässrige Parmaganat/Manganat Lösungen Verwendung finden.

Ausführungsbeispiele der Erfindung sind in den folgenden Figuren näher beschrieben. Es stellt dar:

**Figur 1**

Das Resonanzrohr im als Parabolreflektor gestalteten Behälter.

Der verwendete Rohrresonator kann in der seitlichen Projektion dargestellt als punktförmige rundum abstahlende Schallquelle gesehen werden. Die geometrische Form der Parabel ermöglicht die parallel zu ihrer Achse verlaufende Reflexion von Strahlen bzw. Wellen, die in ihrem Brennpunkt erzeugt werden. Diese Eigenschaft führte dazu, das Resonatorrohr in einem parabelförmigen Trog direkt mit dessen Symmetrielinie kongruent zur Brennachse einzubringen.

**Figur 2**

Den Resonator in Schrägstellung zur Parabolbrennachse.

**Figur 3**

Den Arbeitsbehälter eingebaut im Sammelabteil, ausgestattet mit Schalldüse.

**Figur 4**

Resonanzrohr mit Reflektor als Hohlkammereinheit.

Bei der technischen Realisierung wird der Reflektortrog als Einbau in ein Sammelabteil eingebracht. Ausgerüstet mit Schwalldüsen wird für eine ausreichende Überflutung der Arbeitsebene gesorgt, ohne die für eine gute Schallankopplung erforderliche entgaste Losung zu stark durchzumischen.

Als nahezu ideal kann das Rohrresonatorsysteme zur Nachrüstung konventioneller Anlagen gesehen werden. Der Einbau erfolgt ähnlich eines Tauchbadwärmers. Gewunschtenfalls kann ein zusätzlicher Reflektoreinbau vorgenommen werden. Durch geeignete Gestaltung des Reflektors kann der Ultraschall praktisch in jede gewünschte Richtung abgestrahlt werden.

Der Reflektor wird vornehmlich als Hohlkammereinheit ausgeführt um die optimalen Reflexionsbedingungen für Ultraschall zu erfüllen. Die erforderliche Mindestspaltbreite sollte $10^{-3}$ mm nicht unterschreiten. Als Medium im Reflektionsspalt wäre Vakuum ideal, Luft stellt aber einen tragbaren Kompromiß dar.

In den Figuren bedeutet:
1 Resonatorrohr
2 Parabelreflektor (Innenbehälter)
3 Energiemaximun (qualitativ)
4 Schwalldüse
5 Transportsystem/Dichtwalzen
6 Substrat
7 Außenbehälter
8 Hohlkammerreflektor

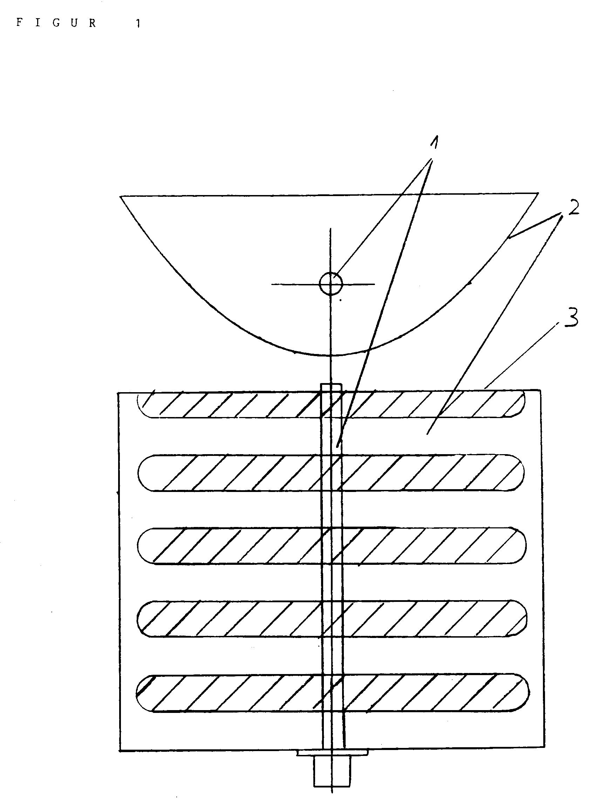

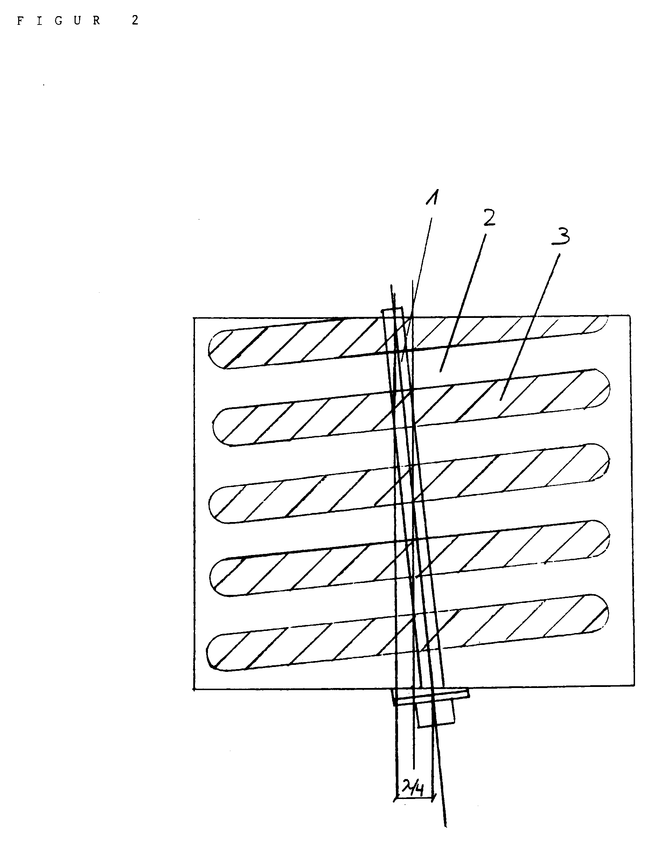

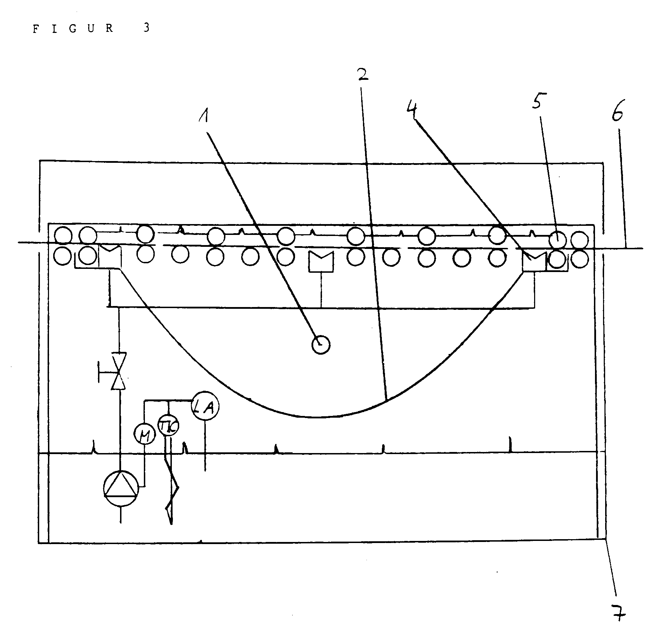

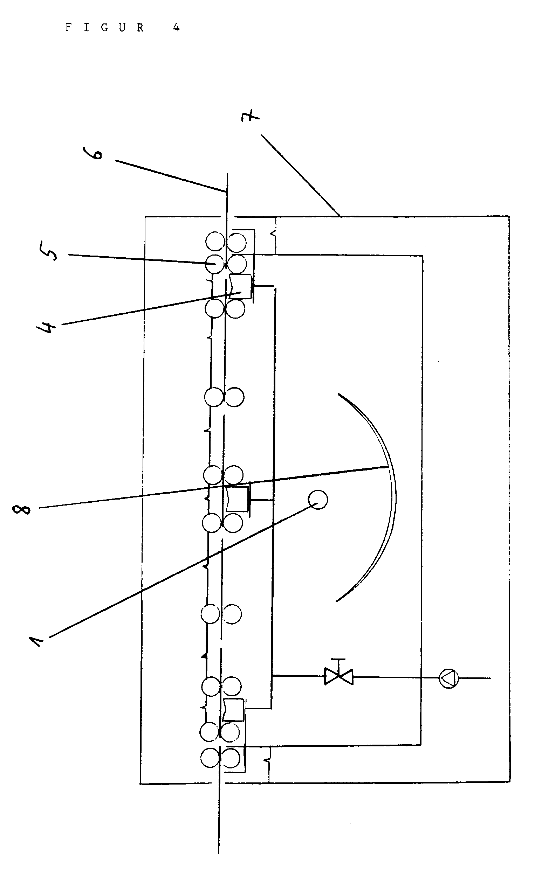

**Patentansprüche**

1. Vorrichtung zur Ultrareinigung von horizontal bewegten Leiterplatten mit flüssigen Reinigungsmitteln, enthaltend einen Behälter für die flüssigen Reinigungsmittel sowie mindestens eine Düse zur Beschwallung der Leiterplatten und insbesondere ihrer Bohrlocher zum Zwekke einer intensiven Durchflutung unter Ausbildung einer vorzugsweise stehenden Welle sowie Antriebssysteme für die Leiterplatten, vorzugsweise durch Rollen, und Abdichtungen zur Verhinderung des Austretens von Flüssigkeit bei der Einbringung in bzw. Ausbringung aus dem Behälter sowie Ultraschallschwinger, dadurch gekennzeichnet, daß der Behälter die Form eines Parabolreflektors aufweist.

2. Vorrichtung gemäß Anspruch 1, dadurch gekennzeichnet, daß der Behälter mit einem Ultraschallschwinger ausgestattet ist.

3. Vorrichtung gemäß Anspruch 2, dadurch gekennzeichnet, daß der Ultraschallschwinger einen Schallwandler mit einem daran angeschlossenen hohlausgebildeten Resonator darstellt.

4. Vorrichtung gemäß Anspruch 3, dadurch gekennzeichnet, daß der Resonator im schiefen Winkel zur Bewegungsrichtung der Platten angeordnet ist.

5. Eine Vorrichtung gemäß Anspruch 1, dadurch gekennzeichnet, daß der Behälter zusätzlich mit einem beweglich angeordneten Hohlkammerreflektor ausgestattet ist.

6. Vorrichtung gemäß Anspruch 1, dadurch gekennzeichnet, daß die Düse im oberen Teil eines Düsengehäuses angeordnet ist, das aus einer Vorkammer mit Einlaufstutzen gebildet wird, die mitels einer Lochmaske vom oberen Teil des Düseninnenraums abgetrennt ist.

7. Vorrichtung gemaß Anspruch 6, dadurch gekennzeichnet, daß die Düse in Form einer Perforationsebene vorliegt, die geschlitzt, gelocht oder symmetrisch beziehungsweise unsymmetrisch durchbrochen ist.

8. Vorrichtung gemäß Anspruch 6, dadurch gekennzeichnet, daß der obere Teil des Düsengehäuses eine zur Düse abfallende Ebene aufweist.

9. Verfahren zur Ultrareinigung von horizontal geführten Leiterplatten, dadurch gekennzeichnet, daß eine Vorrichtung gemäß den Ansprüchen 1 - 8 verwendet wird, wobei durch den Behälter geführte Leiterplatten und deren Bohrlöcher mit dem flüssigen Reinigungsmittel beschwallt werden und gleichzeitig Ultraschallenergie erzeugt und auf die Platten abgestrahlt wird.

**Claims**

1. An apparatus for ultra-cleaning circuit boards that are moved horizontally, using a liquid cleaning agent, comprising a container for the liquid cleaning agent, said container being in the form of a parabolic reflector, at least one nozzle for flooding the printed-circuit boards and in particular drilled holes therein to provide for intensive ultrasonic cleaning thereof, drive means for moving the printed-circuit boards through said apparatus, and ultrasonic oscillator means for supplying ultrasonic energy to said container.

2. An apparatus as claimed in claim 1 arranged to form a standing wave in said container.

3. An apparatus as claimed in claim 1, wherein said drive means incorporate rollers and seals to prevent the liquid from escaping during placement in or removal from the container.

4. An apparatus as claimed in claim 1, wherein ultrasonic oscillator means comprises an ultrasonic oscillator fitted in the container.

5. An apparatus as claimed in claim 4, wherein the ultrasonic oscillator is a sonic converter with a cavity resonator connected thereto.

6. An apparatus as claimed in claim 4, wherein the cavity resonator is arranged at an acute angle to the direction of movement of the boards.

7. An apparatus as claimed in claim 1, wherein the container is also provided with a movable cavity reflector.

8. An apparatus as claimed in claim 1, wherein the nozzle is arranged in the upper part of a nozzle housing that is formed from a pre-chamber with inlet connectors, which is separated from the upper part of the interior nozzle chamber by means of a perforated masking plate.

9. An apparatus as claimed in claim 8, wherein the nozzle is in the form of a perforated plate that is slotted, perforated, or interrupted either symmetrically or asymmetrically.

**Revendications**

1. Dispositif pour l'ultranettoyage de cartes imprimées déplacées horizontalement avec des produits à nettoyer liquides, comprenant un récipient pour les produits à nettoyer liquides ainsi qu'au moins une tuyère pour arroser au jet les cartes imprimées, et, surtout, leurs forures afin d'obtenir une traversée intensive et la formation d'une onde de préférence stationnaire, ainsi que des systèmes d'entraînement pour les cartes imprimées, de préférence par des rouleaux, et des étanchéités pour empêcher un débordement de liquide lors de la mise en place dans le récipient et lors du retrait du récipient, ainsi qu'un émetteur d'ultrasons, ledit dispositif étant caractérisé en ce que le récipient présente la forme d'un réflecteur parabolique.

2. Dispositif selon la revendication 1, caractérisé en ce que le récipient est équipé d'un émetteur d'ultrasons.

3. Dispositif selon la revendication 2, caractérisé en ce que l'émetteur d'ultrasons présente la forme d'un transducteur sonore avec un résonateur à cavité connecté.

4. Dispositif selon la revendication 3, caractérisé en ce que le résonateur est disposé à angle oblique par rapport à la direction de mouvement des cartes.

5. Dispositif selon la revendication 1, caractérisé en ce que le récipient est en outre équipé d'un réflecteur à cavité mobile.

6. Dispositif selon la revendication 1, caractérisé en ce que la tuyère est installée dans la partie plus haute d'une boîte à tuyère formée par une avant-chambre avec tuyau d'entré et séparée de la partie supérieure de l'espace intérieure de la tuyère par un masque perforé.

7. Dispositif selon la revendication 6, caractérisé en ce que la tuyère a la forme d'un plan perforé qui peut être fendu, perforé ou ajouré en forme symétrique ou asymétrique.

8. Dispositif selon la revendication 6, caractérisé en ce que la partie supérieure de la boîte à tuyère comporte un plan incliné en direction de la tuyère.

9. Procédé pour l'ultranettoyage de cartes imprimées amenées horizontalement, caractérisé en ce qu'un dispositif selon les revendications 1 à 8 est utilisé, les cartes imprimées amenées au travers du récipient et leurs forures étant arrosées au jet avec le produit à nettoyer liquide et une énergie ultrasonique étant simultanément générée puis dégagée sur les cartes.

F I G U R   1

FIGUR 2

FIGUR 3

FIGUR 4